# EUROPEAN PATENT SPECIFICATION

(11) **EP 2 730 406 B1**
(45) Date of publication and mention of the grant of the patent: **10.11.2021**
(21) Application number: 14154101.1
(22) Date of filing: 22.06.2006
(51) Int. Cl.: B32B 27/30, H01L 31/042, B32B 17/10, C09D 127/18, C08K 3/22

(54) **Back sheet of solar cell**
Rückseitenfolie einer Solarzelle
Feuille support de cellule solaire

(30) Priority: 22.07.2005 JP 2005212550
(43) Date of publication of application: 14.05.2014
(62) Divisional of application: 11180177.5
(73) Proprietor: DAIKIN INDUSTRIES, LTD., Osaka-shi Osaka 530-8323 (JP)
(72) Inventor: Meiji, Kazuhiro, Osaka, 566-8585 (JP); Nagato, Masaru, Osaka, 566-8585 (JP); Higuchi, Tatsuya, Osaka, 566-8585 (JP); Kato, Masami, Osaka, 566-8585 (JP)
(74) Representative: Hoffmann Eitle

(56) References cited:
- JP-A- 8 330 618
- JP-A- 10 306 129
- JP-A- 62 007 767
- JP-A- 2000 114 564
- JP-A- 2000 138 388
- JP-A- 2001 089 625
- JP-A- 2002 327 018
- JP-B- 1 016 405
- US-B1- 6 369 316
- DATABASE WPI Week 200230 Thomson Scientific, London, GB; AN 2002-257217 XP002522001, & JP 2002 026343 A (BRIDGESTONE CORP) 25 January 2002 (2002-01-25)
- None

## Description

### BACK SHEET OF SOLAR CELL

### TECHNICAL FIELD

The present invention relates to a solar cell module having a back sheet having excellent adhesion to ethylene/vinyl acetate copolymer used as a sealing agent for solar cells.

### BACKGROUND ART

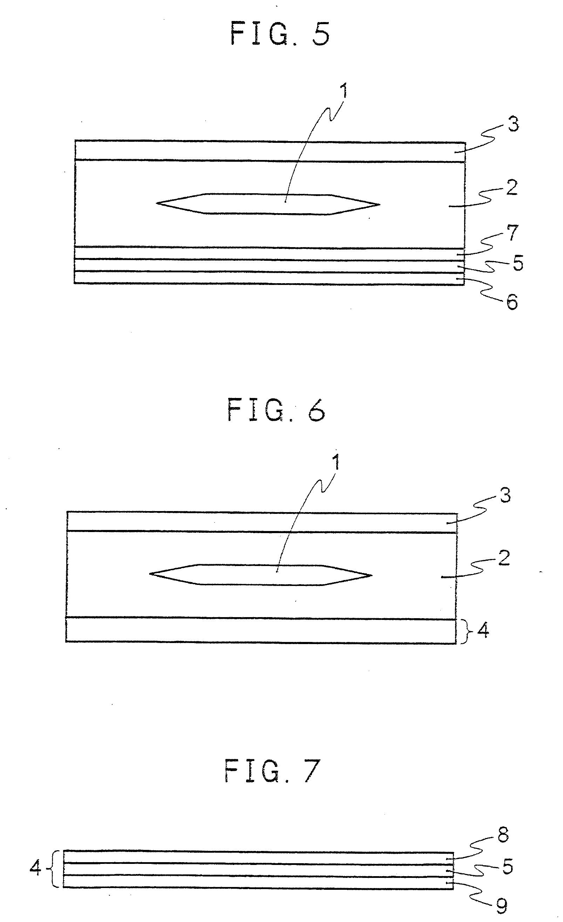

A solar cell module usually has a laminated structure such that as shown in Fig. 6, a solar cell 1 is sealed with a sealant layer 2, and the sealed cell is sandwiched between a surface layer 3 and a back sheet 4. Ethylene/vinyl acetate copolymer (EVA) is used as a sealant.

The back sheet 4 of the solar cell module has an aim of increasing mechanical strength of the module, and in addition, a function of preventing water (steam) from permeating the sealant layer 2.

As shown in Fig. 7, the back sheet 4 is comprised of a water-impermeable sheet 5 as a barrier for preventing steam permeation and a resin sheet 8 laminated on one surface of the water-impermeable sheet. Usually a resin sheet 9 is laminated on another surface of the water-impermeable sheet.

Examples of materials of the water-impermeable sheet 5 are silicon-deposited polyester (silicon-deposited PET) having excellent water impermeability and metals such as aluminum and stainless steel, and the thickness of the sheet 5 is usually from 10 to 20 µm.

The resin sheets 8 and 9 are required to have characteristics such as weather resistance, electrical insulation, flame retardance and property for exhibiting design pattern, and a polyvinyl fluoride polymer (PVF) sheet is used therefor. In some cases, a polyethylene sheet is used as the resin sheet 8 at the side of the sealant layer 2.

However, usually it is necessary that the thickness of these resin sheets is from 20 to 100 µm in order to satisfy required weather resistance, electrical insulation and light-shielding property. Therefore further weight reduction is demanded.

To satisfy such a demand, there is proposed formation of a similar layer using a resin coating instead of a resin sheet (JP7-176775A and JP2004-214342A).

In JP7-176775A, an epoxy resin coating is used as a resin coating. However, an epoxy resin is insufficient in weather resistance, and has not been put into practical use.

In JP2004-214342A, there is proposed a back sheet of two-layer structure produced by coating a metallic substrate (water-impermeable sheet) with a PVdF coating prepared by blending a specific amount of tetraalkoxysilane or a partly hydrolyzed compound thereof to PVdF having no functional group. This PVdF coating alone is inferior in adhesion to EVA being a sealant because PVdF has no functional group. In JP2004-214342A, this point is improved by blending a specific amount of tetraalkoxysilane or a partly hydrolyzed compound thereof, thus causing orientation of tetraalkoxysilane or a partly hydrolyzed compound thereof toward an interface with EVA. However, since tetraalkoxysilane or a partly hydrolyzed compound thereof exists locally around the interface with EVA, adhesion of a PVdF coating film to a metallic substrate still is not improved. Further, PVdF is a crystalline compound and has no functional group, and in order to form a coating film, the coating must be subjected to baking by heating at 200° to 300°C for 20 to 120 seconds. Therefore, coating on water-impermeable sheets other than metals is difficult.

JP 8330618 describes a light-transmitting glass 1 consisting of, for instance, soda quartz glass or the like that is arranged on the front side of a solar battery element 2. A circular projection part 1a is formed on the front side of light-transmitting glass 1. The projection part 1a is so formed for instance, that a diameter of the circle may be 3mm and a pitch may be about 7mm. In this way, when the circular projection parts 1 are formed covering nearly the whole surface of the light-transmitting glass, reflection light is scattered even if sunlight irradiates this light-transmitting glass 1. Accordingly, sun light is prevented from reflecting in the same direction.

### DISCLOSURE OF INVENTION

It is an object of the present invention to provide a solar cell module having a back sheet having excellent adhesion property to a water-impermeable sheet.

With respect to other problems to be solved, explanation is made according to specific embodiments.

Namely, the present invention relates to a solar cell module provided with a back sheet having, on a water-impermeable sheet at the opposite side of a sealant layer of the solar cell module, a cured coating film of a coating material comprising a fluorine-containing polymer, characterized in that the fluorine-containing polymer has a curable functional group, wherein the cured coating film is adhered directly to the water-impermeable sheet, and a white pigment or a black pigment is dispersed in the cured coating film. The back sheet may be a two-layer structure having, only on either surface of the water-impermeable sheet, a cured coating film of a coating material comprising a fluorine-containing polymer having curable functional group, a three-layer structure having, on both surfaces of the water-impermeable sheet, cured coating films of a coating material comprising a fluorine-containing polymer having curable functional group, or a three-layer structure having, on one surface of the water-impermeable sheet, a cured coating film of a coating material comprising a fluorine-containing polymer having curable functional group, and, on another surface thereof, a cured coating film of a coating material comprising a fluorine-containing polymer having no curable functional group, a fluorine-containing polymer sheet, a polyester sheet or a coating film of a polyester coating material (hereinafter may be referred to as "other sheet or coating film").

In addition, known one or two or more intermediate layers may exist between the water-impermeable sheet and the cured coating film and/or other sheet or coating film in order to improve adhesion and hiding property and decrease steam permeation. Represented example of such an intermediate layer is a primer layer.

Examples of the water-impermeable sheet which can be preferably used are silicon-deposited polyester sheet or metallic sheets.

In the case of providing a cured coating film of a coating material comprising a fluorine-containing polymer having curable functional group on the surface of the water-impermeable sheet at the side of a sealant (usually EVA) layer of solar cell module, the functional group of the fluorine-containing polymer having curable functional group undergoes co-crosslinking with EVA, thereby further improving adhesion.

In addition, from the viewpoint of appearance of the solar cell module, it is preferable to disperse a pigment in the cured coating film of a coating material comprising a fluorine-containing polymer having curable functional group. From this point of view, a fluorine-containing tetrafluoroethylene (TFE) polymer having curable functional group and being excellent in dispersibility of a pigment is preferable.

### BRIEF DESCRIPTION OF DRAWINGS

Fig. 1 is a diagrammatic cross-sectional view of the first embodiment of the solar cell module of the present invention.
Fig. 2 is a diagrammatic cross-sectional view of the second embodiment of the solar cell module of the present invention.
Fig. 3 is a diagrammatic cross-sectional view of the third embodiment of the solar cell module of the present invention.
Fig. 4 is a diagrammatic cross-sectional view of the fourth embodiment of the solar cell module of the present invention.
Fig. 5 is a diagrammatic cross-sectional view of the fifth embodiment of the solar cell module of the present invention.
Fig. 6 is a diagrammatic cross-sectional view of a conventional solar cell module.
Fig. 7 is a diagrammatic cross-sectional view of a back sheet of a conventional solar cell module.

### BEST MODE FOR CARRYING OUT THE INVENTION

The feature of the back sheet of the present invention is that a cured coating film of a coating material comprising a fluorine-containing polymer having curable functional group is used as a polymer layer to be provided for imparting weather resistance, shielding property, chemical resistance, moisture resistance and salt resistance.

A coating composition comprising a fluorine-containing polymer having curable functional group as a film forming component is used as the coating material comprising a fluorine-containing polymer having curable functional group which is used to form such a cured coating film.

Examples of the fluorine-containing polymer having curable functional group are polymers obtained by introducing functional group to fluorine-containing polymers. The fluorine-containing polymer encompasses resinous polymers having a definite melting point, elastomeric polymers exhibiting rubber elasticity and thermoplastic elastomeric polymers which are intermediates between the former two kinds of polymers.

Examples of the functional group giving curability to the fluorine-containing polymer are, for instance, hydroxyl, carboxyl, amino, glycidyl, silyl, silanate, isocyanate and the like, and the functional group is optionally selected from the viewpoint of easy preparation of the polymer and depending on a curing system. Among them, hydroxyl, cyano and silyl are preferable from the viewpoint of satisfactory curing reactivity, and especially hydroxyl is preferable from the viewpoint of availability of a polymer and good reactivity. These curable functional groups are usually introduced to the fluorine-containing polymer by copolymerization of a monomer having curable functional group.

Nonlimiting examples of a monomer having curable functional group are those exemplified below.

### (1-1) Hydroxyl-containing monomer:

Examples of hydroxyl-containing monomer are, for instance, hydroxyl-containing vinyl ethers such as 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether and 6-hydroxyhexyl vinyl ether; hydroxyl-containing allyl ethers such as 2-hydroxyethyl allyl ether, 4-hydroxybutyl allyl ether and glycerol monoallyl ether; and the like. Among these, hydroxyl-containing vinyl ethers, especially 4-hydroxybutyl vinyl ether and 2-hydroxyethyl vinyl ether are preferable from the viewpoint of satisfactory polymerization reactivity and curability of functional group.

Examples of other hydroxyl-containing monomer are, for instance, hydroxyalkyl esters of (meth)acrylic acids such as 2-hydroxyethyl acrylate and 2-hydroxyethyl methacrylate.

### (1-2) Carboxyl-containing monomer:

Examples of carboxyl-containing monomer are, for instance, unsaturated carboxylic acids such as unsaturated monocarboxylic acids, unsaturated dicarboxylic acids, and monoesters and acid anhydrides thereof which are represented by the formula (II) 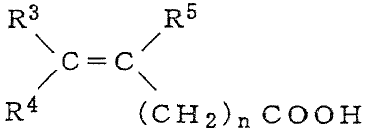 wherein R³, R⁴ and R⁵ are the same or different and each is hydrogen atom, an alkyl group, carboxyl or an ester group; n is 0 or 1;
or carboxyl-containing vinyl ether monomers represented by the formula (III): 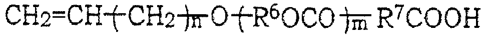 wherein R⁶ and R⁷ are the same or different and each is an saturated or unsaturated linear or cyclic alkyl group; n is 0 or 1; m is 0 or 1.

Examples of the unsaturated carboxylic acids of the formula (II) are, for instance, acrylic acid, methacrylic acid, vinylacetic acid, crotonic acid, cinnamic acid, 3-allyloxypropionic acid, 3-(2-allyloxyethoxycarbonyl)propionic acid, itaconic acid, itaconic acid monoester, maleic acid, maleic acid monoester, maleic anhydride, fumaric acid, fumaric acid monoester, vinyl phthalate and vinyl pyromellitate. Among these, crotonic acid, itaconic acid, maleic acid, maleic acid monoester, fumaric acid, fumaric acid monoester and 3-allyloxypropionic acid having low homopolymerizability are preferably since a homopolymer is hardly prepared due to low homopolymerizability.

Examples of the carboxyl-containing vinyl ether monomers of the formula (III) are, for instance, one or two or more kinds of 3-(2-allyloxyethoxycarbonyl)propionic acid, 3-(2-allyloxybuthoxycarbonyl)propionic acid, 3-(2-vinyloxyethoxycarbonyl)propionic acid and 3-(2-vinyloxybuthoxycarbonyl)propionic acid. Among these, 3-(2-allyloxyethoxycarbonyl)propionic acid is preferable from the viewpoint of satisfactory stability of the monomer and satisfactory polymerization reactivity.

### (1-3) Amino-containing monomer:

Examples of the amino-containing monomers are, for instance, amino vinyl ethers represented by CH₂=CH-O-(CH₂)ₓ-NH₂ (x is 0 to 10); allyl amines represented by CH₂=CH-O-CO(CH₂)ₓ-NH₂ (x is 0 to 10); aminomethylstyrene, vinylamine, acrylamide, vinylacetamide, and vinylformamide.

### (1-4) Silicone vinyl monomer:

Examples of silicone vinyl monomers are, for instance, (meth)acrylic acid esters such as CH₂=CHCO₂(CH₂)₃Si(OCH₃)₃, CH₂=CHCO₂(CH₂)₃Si(OC₂H₃)₃, CH₂=C(CH₃)CO₂(CH₂)₃Si(OCH₃)₃, CH₂=C(CH₃)CO₂(CH₂)₃Si(OC₂H₅)₃, CH₂=CHCO₂(CH₂)₃SiCH₃(OC₂H₅)₂, CH₂=C(CH₃)CO₂(CH₂)₃SiC₂H₅(OCH₃)₂, CH₂=C(CH₃)CO₂(CH₂)₃Si(CH₃)₂(OC₂H₅), CH₂=C(CH₃)CO₂(CH₂)₃Si(CH₃)₂OH, CH₂=CH(CH₂)₃Si(OCOCH₃)₃, CH₂=C(CH₃)CO₂(CH₂)₃SiC₂H₅(OCOCH₃)₂, CH₂=C(CH₃)CO₂(CH₂)₃SiCH₃(N(CH₃)COCH₃)₂, CH₂=CHCO₂(CH₂)₃SiCH₃[ON(CH₃)C₂H₅]₂ and CH₂=C(CH₃)CO₂(CH₂)₃SiC₆H₅[ON(CH₃)C₂H₅]₂; vinyl silanes such as CH₂=CHSi[ON=C(CH₃)(C₂H₅)]₃, CH₂=CHSi(OCH₃)₃, CH₂=CHSi(OC₂H₅)₃, CH₂=CHSiCH₃(OCH₃)₂, CH₂=CHSi(OCOCH₃)₃, CH₂=CHSi(CH₃)₂(OC₂H₅), CH₂=CHSi(CH₃)₂SiCH₃(OCH₃)₂, CH₂=CHSiC₂H₅(OCOCH₃)₂, CH₂=CHSiCH₃[ON(CH₃)C₂H₅]₂, vinyltrichlorosilane and partly hydrolyzed compounds thereof; and vinyl ethers such as trimethoxysilylethylvinylether, triethoxysilylethylvinylether, trimethoxysilylbutylvinylether, methyldimethoxysilylethylvinylether, trimethoxysilylpropylvinylether and triethoxysilylpropylvinylether.

Examples of fluorine-containing polymers to which a curable functional group is introduced are, for instance, those mentioned below from the viewpoint of structural unit.
(1) Perfluoroolefin polymers comprising perfluoroolefin unit as main component
   Examples are a tetrafluoroethylene (TFE) homopolymer, copolymers of TFE with hexafluoropropylene (HFP) and perfluoro(alkyl vinyl ether), and in addition, copolymers of these with other copolymerizable monomer.
   Nonlimiting examples of other copolymerizable monomer are, for instance, vinyl esters of carboxylic acid such as vinyl acetate, vinyl propionate, vinyl butyrate, vinyl isobutyrate, vinyl pivalate, vinyl caproate, vinyl versatate, vinyl laurate, vinyl stearate, vinyl cyclohexyl carboxylate, vinyl benzoate and vinyl para-t-butyl benzoate; alkyl vinyl ethers such as methyl vinyl ether, ethyl vinyl ether, butyl vinyl ether and cyclohexyl vinyl ether; non-fluorine-containing olefms such as ethylene, propylene, n-butene and isobutene; and fluorine-containing monomers such as vinylidene fluoride (VdF), chlorotrifluoroethylene (CTFE), vinyl fluoride (VF) and fluorinated vinyl ether.
   Among these, TFE polymers comprising TFE as main component are preferable from the viewpoint that they are excellent in dispersibility of a pigment, weather resistance, copolymerizability and chemical resistance.
   Specific examples of perfluoroolefin polymers having curable functional group are, for instance, a copolymer of TFE, isobutylene, hydroxybutyl vinyl ether and other monomer, a copolymer of TFE, vinyl versatate, hydroxybutyl vinyl ether and other monomer, a copolymer of TFE, VdF, hydroxybutyl vinyl ether and other monomer, and the like, and especially preferable are a copolymer of TFE, isobutylene, hydroxybutyl vinyl ether and other monomer and a copolymer of TFE, vinyl versatate, hydroxybutyl vinyl ether and other monomer.
   Examples of curable TFE polymer coating are ZEFFLE GK series available from DAIKIN INDUSTRIES, LTD.
(2) CTFE polymers comprising chlorotrifluoroethylene (CTFE) unit as main component
   Examples are, for instance copolymers of CTFE, hydroxybutyl vinyl ether and other monomer.
   Examples of curable CTFE polymer coating are, for instance, LUMIFLON available from Asahi Glass Co., Ltd., FLUONATE available from DAINIPPON INK AND CHEMICALS INCORPORATED, CEFRAL COAT available from Central Glass Co., Ltd. and ZAFLON available from TOAGOSEI CO., LTD.
(3) VdF polymers comprising vinylidene fluoride (VdF) unit as main component
   Examples are, for instance copolymers of VdF, TFE, hydroxybutyl vinyl ether and other monomer.
(4) Polymers having fluoroalkyl group and comprising fluoroalkyl unit
   Examples are, for instance, copolymers of CF₃CF₂(CF₂CF₂)ₙCH₂CH₂OCOCH=CH₂ (a mixture of n=3 and n=4), 2-hydroxyethyl methacrylate and stearyl acrylate.

Examples of polymers having fluoroalkyl group are, for instance, UNIDYNE and Ftone available from DAIKIN INDUSTRIES, LTD. and Zonyl available from Du Pont.

Among these, perfluoroolefin polymers are preferable in consideration of weather resistance and moisture resistance.

Coating compositions comprising, as a coating film forming component, these fluorine-containing polymers having curable functional group can be prepared by a usual method in the form of a solvent coating composition, an aqueous coating composition and a powder coating composition. Among these, especially a solvent coating composition is preferable from the viewpoint of easy film formation, curability and drying characteristic.

In addition, various additives can be blended to the coating composition comprising a fluorine-containing polymer having curable functional group according to required characteristics. Examples of additives are a curing agent, a curing accelerator, a pigment, a pigment dispersing agent, a defoaming agent, a leveling agent, a UV absorbent, a photo-stabilizer, a thickener, an adhesion improving agent and a flatting agent.

A curing agent is selected according to the functional group of the curable polymer, and preferable examples thereof for the fluorine-containing polymers having hydroxyl are isocyanate curing agents, melamine resins, silicate compounds and isocyanate group-containing silane compounds. In addition, for the fluorine-containing polymers having carboxyl, amino curing agents and epoxy curing agents are usually used, and for the fluorine-containing polymers having amino group, curing agents having carbonyl group, epoxy curing agents and acid anhydride curing agents are usually used.

Examples of a curing accelerator are known tin-based, other metal-based and organic acid-based curing accelerators and amino curing accelerators.

It is strongly desired to add a pigment from the viewpoint of making appearance of a solar cell module beautiful. Especially a white pigment such as titanium oxide and calcium carbonate, a black pigment such as carbon black, and composite metals such as Cu-Cr-Mn alloy are usually added.

The water-impermeable sheet is a layer to be provided to prevent permeation of water into the sealant EVA and the solar cell, and any materials can be used as far as water does not permeate through them. In many cases, silicon-deposited PET sheet and a thin metallic sheet of aluminum or stainless steel are used from the viewpoint of weight, price and flexibility thereof. Especially silicon-deposited PET sheet is often used. The thickness of the sheet is usually from about 10 µm to about 20 µm.

Also, in order to improve adhesion, the water-impermeable sheet may be subjected to known surface treatment. Examples of the surface treatment are, for instance, corona discharge treatment, plasma discharge treatment and chemical conversion treatment, and in the case of metallic sheet, blasting treatment is employed.

A cured coating film is formed on the water impermeable sheet by coating a coating composition comprising, as a coating film forming component, a fluorine-containing polymer having curable functional group on the water impermeable sheet according to a form of coating composition.

The coating procedures are carried out within usual temperature condition for a form of coating composition. In the case of a solvent coating composition, curing of the coating film is carried out at a temperature of from 10° to 300°C, usually at normal temperature (20° to 30°C). Therefore materials such as silicon-deposited PET sheet for which high temperature treatment should be avoided, can be used as a water impermeable sheet without any problem. The curing is usually completed at 20° to 300°C in one minute to three days.

The coating procedures may be carried out directly on the water impermeable sheet or via a primer layer.

The primer layer is formed by usual method using a known coating for primer. Represented examples of a primer are, for instance, an epoxy resin, a urethane resin, an acrylic resin, a silicone resin and a polyester resin.

The thickness of the cured coating film is preferably not less than 5 µm, further preferably not less than 10 µm, especially preferably not less than 20 µm, from the viewpoint of satisfactory shielding property, weather resistance, chemical resistance and moisture resistance. An upper limit of the thickness is preferably about 1,000 µm, further preferably 100 µm because if the film is too thick, an effect of making its weight smaller cannot be obtained. The thickness is especially preferably 30 to 40 µm.

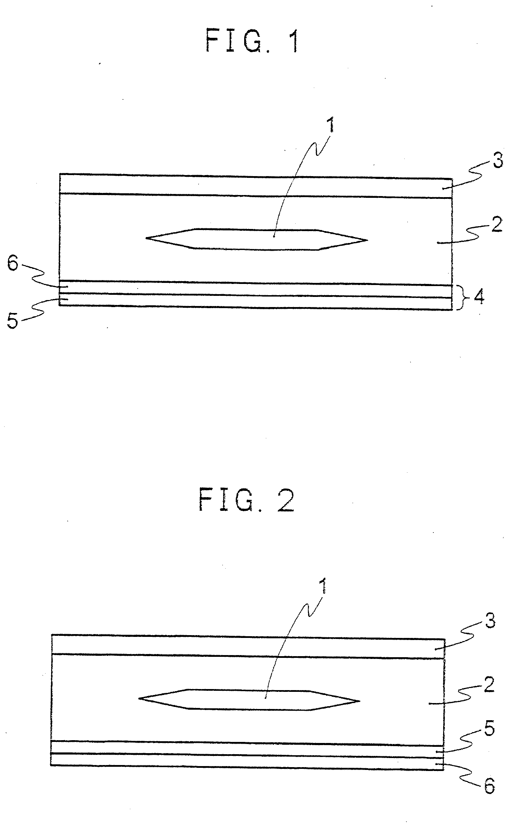

The solar cell module of the present invention is then explained by means of Fig. 1 showing preferable embodiment. Other preferable embodiments of the present invention are shown in Figs. 2 to 5.

In Fig. 1, numeral 1 represents a solar cell which is sealed with a sealant layer 2 represented by EVA, and the sealant layer 2 is sandwiched between the surface layer 3 and the back sheet 4. The back sheet 4 is comprised of the water impermeable sheet 5 and the cured coating film 6 of a coating comprising a fluorine-containing polymer having curable functional group. In this first embodiment, the cured coating film 6 is provided at the side of the sealant (EVA) layer 2.

In this embodiment, since the cured coating film 6 contacts EVA, interfacial adhesion between them is improved especially by co-crosslinking with EVA.

Fig. 2 shows the second embodiment, and the cured coating film 6 is provided on the opposite side of the sealant (EVA) layer 2. In this embodiment, satisfactory weather resistance is exhibited by providing the cured coating film 6. In addition, it is preferable from the viewpoint of improvement of adhesion that the water impermeable sheet 5 is subjected to surface treatment at the side of the sealant (EVA) layer 2. Also, according to necessity, a polyester adhesive, an acryl adhesive, a urethane adhesive or an epoxy adhesive may be used.

The back sheet of the present invention may be a two-layer structure comprising the above-mentioned water impermeable sheet 5 and the cured coating film 6 provided only on one surface of the water impermeable sheet 5, or a three-layer structure explained below.

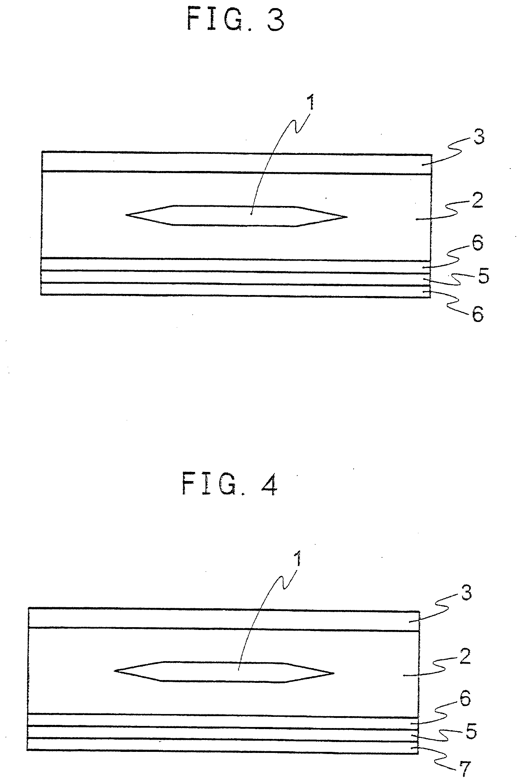

The embodiment (the third embodiment) of the back sheet of three-layer structure is shown in Fig. 3. The third embodiment is a three-layer structure comprising the water impermeable sheet 5 and the cured coating films 6 of a coating comprising a fluorine-containing polymer having curable functional group which are formed on both surfaces of the water impermeable sheet 5.

The third embodiment has advantages of both of the first embodiment and the second embodiment though bringing about regression from the viewpoint of the thickness of the back sheet.

The three-layer back sheet may be one comprising a cured coating film of fluorine-containing polymer coating having curable functional group formed on one surface of the water impermeable sheet, and a cured coating film of fluorine-containing polymer coating having no curable functional group, a fluorine-containing polymer sheet, a polyester sheet or a coating film of polyester coating (other sheet or coating film) formed on another surface of the water impermeable sheet (Fig. 4 and Fig. 5).

The fourth embodiment (Fig. 4) shows a structure having the other coating film 7 formed on the opposite side of the sealant (EVA) layer 2 in the first embodiment, and the fifth embodiment (Fig. 5) shows a structure having the other coating film 7 formed on the side of the sealant (EVA) layer 2 in the second embodiment.

In either of the fourth and fifth embodiments, the layer 7 may be a cured coating film of fluorine-containing polymer coating having no curable functional group, a fluorine-containing polymer sheet, a polyester sheet or a coating film of polyester coating.

Examples of the cured coating film of fluorine-containing polymer coating having no curable functional group are a cured coating film of a coating prepared by adding tetraalkoxysilane or a partly hydrolyzed compound thereof to PVdF, a cured coating film of a coating mixture comprising a VdF/TFE/CTFE copolymer and an acrylic resin having an alkoxysilane unit, a cured coating film of a coating mixture comprising a VdF/TFE/HFP copolymer and an acrylic resin having hydroxyl group, and a cured coating film of a coating prepared by adding an amino silane coupling agent to a VdF/HFP copolymer, which are described in JP2004-214342A. It is preferable that the thickness of the film is usually from 5 to 300 µm, further from 10 to 100 µm, especially from 10 to 50 µm, from the viewpoint of satisfactory shielding property, weather resistance, chemical resistance and moisture resistance. In this case, the coating film may also be formed via a primer layer.

Examples of the fluorine-containing polymer sheet are those used on usual back sheet, such as a PVdF sheet, a PVF sheet, a PCTFE sheet, a TFE/ HFP/ ethylene copolymer sheet, a TFE/HFP copolymer (FEP) sheet, a TFE/PAVE copolymer (PFA) sheet, an ethylene/TFE copolymer (ETFE) sheet, and an ethylene/CTFE copolymer (ECTFE) sheet. It is preferable that the thickness of the sheet is usually from 5 to 300 µm, further from 10 to 100 µm, especially from 10 to 50 µm, from the viewpoint of satisfactory weather resistance.

With respect to the polyester sheet, those used on conventional back sheets can be used as they are. Adhesion of the polyester sheet to the water impermeable sheet 5 can be carried out using an acryl adhesive, a urethane adhesive, an epoxy adhesive or a polyester adhesive. It is preferable that the thickness of the sheet is usually from 5 to 300 µm, further from 10 to 100 µm, especially from 10 to 50 µm, from the viewpoint of satisfactory weather resistance, cost and good transparency.

Examples of the polyester coating are those prepared using a saturated polyester resin comprising polycarboxylic acid and polyalcohol, and those prepared using an unsaturated polyester resin comprising glycol such as maleic anhydride or fumaric acid. The coating film thereof can be formed by a coating method such as roll coating, curtain coating, spray coating or die coating. It is preferable that the thickness is usually from 5 to 300 µm, further from 10 to 100 µm, especially from 10 to 50 µm, from the viewpoint of satisfactory shielding property, weather resistance, chemical resistance and moisture resistance. In this case, too, the layer may be formed using a primer layer.

### EXAMPLE

The present invention is then explained by means of Preparation Examples and Examples, but is not limited to them.

### PREPARATION EXAMPLE 1

223.2 parts by mass of a curable TFE copolymer (ZEFFLE GK570 available from DAIKIN INDUSTRIES, LTD., solid content: 65 % by mass, hydroxyl value: 60 mgKOH/g, a solvent: butyl acetate), 250 parts by mass of a black pigment (DAIPYROXIDE 9510 available from Dainichiseika Color & Chemicals Mfg. Co., Ltd.) and 126.8 parts by mass of butyl acetate were preliminarily mixed with stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution was added 269.2 parts by mass of a curable TFE copolymer (ZEFFLE GK570) to prepare a black coating.

To 100 parts by mass of this black coating were added 7 parts by mass of a curing agent (CORONATE HX available from NIPPON POLYURETHANE INDUSTRY CO., LTD.), 3 parts by mass of a silane coupling agent (NCO-C3H6-Si(OCH3)3) and 100 parts by mass of butyl acetate as a diluting solvent, to prepare a Curable Coating 1.

### PREPARATION EXAMPLE 2

223.2 parts by mass of a curable TFE copolymer (ZEFFLE GK570), 250 parts by mass of titanium oxide (TIPURE R960 available from Du Pont) as a white pigment and 126.8 parts by mass of butyl acetate were preliminarily mixed with stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution was added 269.2 parts by mass of a curable TFE copolymer (ZEFFLE GK570) to prepare a white coating.

To 100 parts by mass of this white coating were added 7 parts by mass of a curing agent (CORONATE HX), 3 parts by mass of a silane coupling agent (NCO-C3H6-Si(OCH3)3) and 100 parts by mass of butyl acetate as a diluting solvent, to prepare a Curable Coating 2.

### PREPARATION EXAMPLE 3

A clear coating was prepared by mixing 100 parts by mass of a curable TFE copolymer (ZEFFLE GK570), 100 parts by mass of butyl acetate and 6 parts by mass of an ultraviolet absorber (Uvinul 3035 available from BASF) with stirring.

To 100 parts by mass of this clear coating were added 7 parts by mass of a curing agent (CORONATE HX), 3 parts by mass of a silane coupling agent (NCO-C3H6-Si(OCH3)3) and 100 parts by mass of butyl acetate as a diluting solvent, to prepare a Comparative Curable Coating 3.

### PREPARATION EXAMPLE 4

A Comparative Non-curable Coating 1 was prepared by adding 30 parts by mass of a silicate compound (METHYLSILICATE 51 available from Colcoat Co., Ltd.) to 100 parts by mass of DICFLOW C (available from NIPPON FINE COATINGS, INC.) being a black enamel coating of PVdF copolymer.

### PREPARATION EXAMPLE 5

223.2 parts by mass of a polyester copolymer (DESMOPHEN 650MPA available from Sumitomo Bayer Urethane Co., Ltd., solid content: 65 % by mass, hydroxyl value: 5.3 mgKOH/g, solvent: methoxypropyl acetate), 250 parts by mass of a black pigment (DAIPYROXIDE 9510) and 126.8 parts by mass of butyl acetate were preliminarily mixed with stirring, and thereto was added 780 parts by mass of glass beads having a diameter of 1.2 mm, followed by dispersing at 1,500 rpm for one hour with a pigment disperser. Then, the glass beads were filtrated with #80 mesh filter, and to the resultant solution was added 269.2 parts by mass of a polyester copolymer (DESMOPHEN 650MPA) to prepare a comparative black coating.

To 100 parts by mass of this comparative black coating were added 13 parts by mass of a curing agent (CORONATE HX available from NIPPON POLYURETHANE INDUSTRY CO., LTD.) and 100 parts by mass of butyl acetate as a diluting solvent, to prepare a Comparative Non-fluorine-containing Curable Coating 2.

### COMPARATIVE EXAMPLE 1'

A silicon-deposited PET film (TECHBARRIER H available from Mitsubishi Plastics, Inc., thickness: 12 µm, Sheet A) was used as a water impermeable sheet, and the Curable Coating 1 prepared in Preparation Example 1 was coated on one surface of this Sheet A by air spray so as to give a dried coating film thickness of 20 µm, followed by drying at 80°C for thirty minutes, to produce a Back Sheet A1 of two-layer structure.

Adhesion (between the coating film and the sheet) and bending characteristic were evaluated using this Back Sheet A1. The results are shown in Table 1.

Then an EVA resin sheet (SOLAR EVA available from Mitsui Chemicals Fabro, Inc., thickness: 400 µm) was placed on the coated surface of the Back Sheet A1, followed by compression at 150°C at a pressure of 100 g/cm², to produce a Sample A1 of three-layer structure (embodiment shown in Fig. 1). Adhesion (between the EVA and the coating film) and weather resistance of this EVA-adhered Sample A1 were evaluated. The results are shown in Table 1.

Test methods and measuring methods are as follows.

### (Adhesion)

Evaluation is made by a cross-cut test (cross-cut to 1 mm width) according to JIS K6900.

### Criteria for evaluation

○: No peeling was found.
×: Peeling exists.
(Weather resistance test)

An accelerated weather resistance test is carried out for 5,000 hours with a sunshine weatherometer (WEL-300 available from Suga Test Instruments Co., Ltd. according to JIS B7753 while subjecting both surfaces of a sample to radiation with sun light.

Evaluation is made by observing an interface between the EVA and the coating film or the sheet and appearance with naked eyes.

### Criteria for evaluation of interface

○: No unusual condition was found.
Δ: Peeling, whitening and blistering are found.
× : Remarkable peeling, whitening and blistering exist.
Criteria for evaluation of appearance
○: No unusual condition was found.
Δ: Peeling, whitening and blistering are found.
× : Remarkable peeling, whitening and blistering exist.

### (Bending characteristic)

The back sheet is cut into a 50 mm × 50 mm test piece. The test piece is wound on a 2 mm diameter round bar so that the coated surface faces outward, and was bent 180 degrees (in one second), and whether or not cracking is found on the bent portion is observed with naked eyes. When cracking is found, two sheets of test pieces are overlapped and then bent 180 degrees in the same manner as above. This is repeated by increasing the number of sheets until cracking is not found, and the number of test pieces is recorded. When the number of test pieces is smaller, bending characteristic is better.

### (Coating thickness)

A thickness is measured with an electromagnetic thickness meter.

### COMPARATIVE EXAMPLE 1

A back sheet A2 of two-layer structure and an EVA-adhered sample A2 of three-layer structure were prepared in the same manner as in Comparative Example 1' except that the Comparative Coating 1 (non-curable PVdF coating) prepared in Preparation Example 4 was used as a coating, and adhesion, bending characteristic and weather resistance were evaluated in the same manner as in Comparative Example 1'. The results are shown in Table 1.

**TABLE 1**

| Structure of back sheet (Fig. 1) | | | Comparative Example 1' | Comparative Example 1 |
|---|---|---|---|---|
| | Coating film | | Curable Coating 1 | Comparative Coating 1 |
| | Water impermeable sheet | | Sheet A | Sheet A |

| Characteristics of back sheet | | | | |
|---|---|---|---|---|
| | Adhesion | | ○ | × |
| | Bending characteristic (Number of sheets) | | 1 | Cracking occurs at 90° |

| Laminated article with EVA (sample) | | | | |
|---|---|---|---|---|
| | Surface of back sheet adhered to EVA | | coating film side | coating film side |
| | Adhesion | | ○ | × |
| | Weather resistance | | | |
| | | Interface with EVA | ○ | × |
| | | Appearance | × | × |

### EXAMPLE 2

A Sample B1 (embodiment shown in Fig. 2) of three-layer structure was prepared by compressing an EVA resin sheet at 150°C at a pressure of 100 g/cm² on the Sheet A of the Back Sheet A1 of two-layer structure produced in the same manner as in Comparative Example 1' by using a polyester adhesive (AD-76P1 and CAT-10L (curing agent) available from Toyo-Morton, Ltd.). Adhesion (between the EVA and the Sheet A) and weather resistance of this EVA-adhered Sample B1 were evaluated. The results are shown in Table 2.

### EXAMPLE 3

A Back Sheet B2 of two-layer structure was prepared using a silicon-deposited PET film (Sheet A) as a water impermeable sheet, by coating the Curable Coating 2 prepared in Preparation Example 2 on one surface of this Sheet A by air spraying so as to give a dried coating film thickness of 20 µm, and then drying at 80°C for thirty minutes.

Adhesion (between the coating film and the sheet) and bending characteristic of this Back Sheet B2 were evaluated. The results are shown in Table 2.

Then, a Sample B2 (embodiment shown in Fig. 2) of three-layer structure was prepared by compressing an EVA resin sheet at 150°C at a pressure of 100 g/cm² on the Sheet A of the Back Sheet B2 by using a polyester adhesive (AD-76P1 and CAT-10L (curing agent) available from Toyo-Morton, Ltd.). Adhesion (between the EVA and the Sheet A) and weather resistance of this EVA-adhered Sample B2 were evaluated. The results are shown in Table 2.

**TABLE 2**

| Structure of back sheet (Fig. 2) | | | Example 2 | Example 3 |
|---|---|---|---|---|
| | Coating film | | Curable Coating 1 | Curable Coating 2 |
| | Water impermeable sheet | | Sheet A | Sheet A |

| Characteristics of back sheet | | | | |
|---|---|---|---|---|
| | Adhesion | | ○ | ○ |
| | Bending characteristic (Number of sheets) | | 1 | 1 |

| Laminated article with EVA (sample) | | | | |
|---|---|---|---|---|
| | Surface of back sheet adhered to EVA | | Sheet A side | Sheet A side |
| | Adhesion | | ○ | ○ |
| | Weather resistance | | | |
| | | Interface with EVA | × | × |
| | | Appearance | ○ | ○ |

### EXAMPLE 4

A Back Sheet C1 of three-layer structure was prepared using a silicon-deposited PET film (Sheet A) as a water impermeable sheet, by coating the Curable Coating 1 prepared in Preparation Example 1 on both surfaces of this Sheet A by air spraying so as to give a dried coating film thickness of 20 µm each, and then drying at 80°C for thirty minutes.

Adhesion (between the coating film and the sheet) and bending characteristic of this Back Sheet C1 were evaluated. The results are shown in Table 3.

Then, a Sample C1 (embodiment shown in Fig. 3) of four-layer structure was prepared by compressing an EVA resin sheet at 150°C at a pressure of 100 g/cm² on one coating film of the Back Sheet C1. Adhesion (between the EVA and the coating film) and weather resistance of this EVA-adhered Sample C1 were evaluated. The results are shown in Table 3.

### EXAMPLE 5

A Back Sheet C2 of three-layer structure was prepared in the same manner as in Example 4 except that an aluminum sheet (Sheet B, 0.5 mm) was used instead of Sheet A, and adhesion (between the coating film and the sheet) and bending characteristic of this Back Sheet C2 were evaluated. The results are shown in Table 3.

Then, a Sample C2 (embodiment shown in Fig. 3) of four-layer structure was prepared by compressing an EVA resin sheet at 150°C at a pressure of 100 g/cm² on one coating film of the Back Sheet C2. Adhesion (between the EVA and the coating film) and weather resistance of this EVA-adhered Sample C2 were evaluated. The results are shown in Table 3.

### EXAMPLE 6

A Back Sheet C3 of three-layer structure was prepared using a silicon-deposited PET film (Sheet A) as a water impermeable sheet, by coating the Curable Coating 2 prepared in Preparation Example 2 on both surfaces of this Sheet A by air spraying so as to give a dried coating film thickness of 20 µm each, and then drying at 80°C for thirty minutes.

Adhesion (between the coating film and the sheet) and bending characteristic of this Back Sheet C3 were evaluated. The results are shown in Table 3.

Then, a Sample C3 (embodiment shown in Fig. 3) of four-layer structure was prepared by compressing an EVA resin sheet at 150°C at a pressure of 100 g/cm² on one coating film of the Back Sheet C3. Adhesion (between the EVA and the coating film) and weather resistance of this EVA-adhered Sample C3 were evaluated. The results are shown in Table 3.

### EXAMPLE 7

A silicon-deposited PET film (Sheet A) was used as a water impermeable sheet, and the Curable Coating 1 prepared in Preparation Example 1 was coated on one surface of this Sheet A by air spraying so as to give a dried coating film thickness of 20 µm, and the Comparative Curable Coating 3 prepared in Preparation Example 3 was coated on another surface of the Sheet A by air spraying so as to give a dried coating film thickness of 20 µm, followed by drying at 80°C for thirty minutes, to produce a Back Sheet C4 of three-layer structure.

Adhesion (between the coating film of Comparative Cured Coating 3 and the sheet) and bending characteristic of this Back Sheet C4 were evaluated. The results are shown in Table 3.

Then an EVA resin sheet was placed on the coating film surface of Curable Coating 3 of the Back Sheet C4, followed by compression at 150°C at a pressure of 100 g/cm², to produce a Sample C4 of four-layer structure (embodiment shown in Fig. 3). Adhesion (between the EVA and the coating film) and weather resistance of this EVA-adhered Sample C4 were evaluated. The results are shown in Table 3.

### COMPARATIVE EXAMPLE 2

A back sheet C5 of three-layer structure (embodiment shown in Fig. 7) and an EVA-adhered sample C5 of four-layer structure were prepared in the same manner as in Example 4 except that the Comparative Curable Coating 2 (non-fluorine-containing curable coating) prepared in Preparation Example 5 was used as a coating, and adhesion, bending characteristic and weather resistance were evaluated in the same manner as in Comparative Example 1'. The results are shown in Table 3.

### COMPARATIVE EXAMPLE 3

A Back Sheet C6 of three-layer structure was prepared by adhering polyvinyl fluoride (PVF) films (Tedler available from DU PONT-MITSUI POLYCHEMICALS, containing a black pigment, thickness: 10 µm) to both surfaces of Sheet A by using a polyester adhesive.

Adhesion (between the Sheet A and the PVF film) and bending characteristic of this Back Sheet C6 were evaluated. The results are shown in Table 3.

Then, a Sample C6 of four-layer structure (embodiment shown in Fig. 3) was prepared by compressing an EVA resin sheet at 150°C at a pressure of 100 g/cm² on the surface of one PVF film of the Back Sheet C6 by using a polyester adhesive (AD-76P1 and CAT-10L (curing agent) available from Toyo-Morton, Ltd.). Adhesion (between the EVA and the PVF film) and weather resistance of this EVA-adhered Sample C6 were evaluated. The results are shown in Table 3.

**TABLE 3**

| Structure of back sheet (Fig. 3) | | | Ex. 4 | Ex. 5 | Ex. 6 | Ex. 7 | Com. Ex. 2 | Com. Ex. 3 (Fig. 7) |
|---|---|---|---|---|---|---|---|---|
| | Coating film | | Curable Coating 1 | Curable Coating 1 | Curable Coating 2 | Comparative Curable Coating 3 | Comparatie Curable Coating 2 | PVF film |
| | Water impermeable sheet | | Sheet A | Sheet B | Sheet A | Sheet A | Sheet A Comparativ | Sheet A |
| | Coating film | | Curable Coating 1 | Curable Coating 1 | Curable Coating 2 | Curable Coating 1 | e Curable Coating 2 | PVF film |
| Characteristics of back sheet | | | | | | | | |
| | Adhesion | | ○ | ○ | ○ | ○ | ○ | Δ |
| | Bending characteristic (Number of sheets) | | 1 | 1 | 1 | 1 | Cracking occurs at 90° | 1 |
| Laminated article with EVA (sample) | | | | | | | | |
| | Surface of back sheet adhered to EVA | | coating film side | coating film side | coating film side | coating film side (Comparative Curable Coating 3) | coating film side | film side |
| | Adhesion | | ○ | ○ | ○ | ○ | ○ | Δ |
| | Weather resistance | | | | | | | |
| | | Interface with EVA | ○ | ○ | ○ | ○ | × | Δ |
| | Appearance | | ○ | ○ | ○ | ○ | × | Δ |

### COMPARATIVE EXAMPLE 8

A Back Sheet D1 of three-layer structure was prepared by adhering a polyester (PET) film (Lumilar available from TORAY INDUSTRIES, INC., containing a white pigment, thickness: 75 µm) to the surface of the Sheet A of the Back Sheet A1 of two-layer structure produced in Comparative Example 1' by using a polyester adhesive.

Adhesion (between the sheet A and the PET film) and bending characteristic of this Back Sheet D1 were evaluated. The results are shown in Table 4.

Then, a Sample D1 of four-layer structure (embodiment shown in Fig. 4) was prepared by compressing an EVA resin sheet at 150°C at a pressure of 100 g/cm² on the surface of the coating film of Curable Coating 1 of the Back Sheet D1. Adhesion (between the EVA and the coating film) and weather resistance of this EVA-adhered Sample D1 were evaluated. The results are shown in Table 4.

### EXAMPLE 9

A sample D2 of four-layer structure (embodiment shown in Fig. 5) was prepared by compressing an EVA resin sheet at 150°C at a pressure of 100 g/cm² on the surface of the PET film of the Back Sheet D1 of three-layer structure prepared in the same manner as in Comparative Example 8. Adhesion (between the EVA and the PET film) and bending characteristic of this EVA-adhered Sample D2 were evaluated. The results are shown in Table 4.

**TABLE 4**

| Structure of back sheet | | | Comparative Example 8 (Fig. 4) | Example 9 (Fig. 5) |
|---|---|---|---|---|
| | Coating film or film | | Curable Coating 1 | PET film |
| | Water impermeable sheet | | Sheet A | Sheet A |
| | Coating film or film | | PET film | Curable Coating 1 |
| Characteristics of back sheet | | | | |
| | Adhesion | | ○ | ○ |
| | Bending characteristic (Number of sheets) | | 1 | 1 |
| Laminated article with EVA (sample) | | | | |
| | Surface of back sheet adhered to EVA | | coating film side | PET film side |
| | Adhesion | | ○ | ○ |
| | Weather resistance | | | |
| | | Interface with EVA | ○ | × |
| | | Appearance | × | ○ |

### COMPARATIVE EXAMPLE 10

A solar cell module (embodiment of Fig. 1) was produced by placing an EVA resin sheet, a solar cell, an EVA resin sheet and a glass sheet in this order on the coating film surface of Back Sheet A1 of two-layer structure produced in Comparative Example 1', and then compressing in vacuo at 150°C at a pressure of 100 g/cm².

### EXAMPLE 11

A solar cell module (embodiment of Fig. 2) was produced by placing an EVA resin sheet via a polyester adhesive, a solar cell, an EVA resin sheet and a glass sheet in this order on the surface of Sheet A of Back Sheet A1 of two-layer structure produced in Comparative Example 1', and then compressing in vacuo at 150°C at a pressure of 100 g/cm².

### EXAMPLE 12

A solar cell module (embodiment of Fig. 3) was produced by placing an EVA resin sheet, a solar cell, an EVA resin sheet and a glass sheet in this order on the coating film surface of Back Sheet C1 of three-layer structure produced in Example 4, and then compressing in vacuo at 150°C at a pressure of 100 g/cm².

### EXAMPLE 13

A solar cell module (embodiment of Fig. 4) was produced by placing an EVA resin sheet, a solar cell, an EVA resin sheet and a glass sheet in this order on the coating film surface of Back Sheet D1 of three-layer structure produced in Comparative Example 8, and then compressing in vacuo at 150°C at a pressure of 100 g/cm².

### EXAMPLE 14

A solar cell module (embodiment of Fig. 5) was produced by placing an EVA resin sheet, a solar cell, an EVA resin sheet and a glass sheet in this order on the PET film surface of Back Sheet D2 of three-layer structure produced in Example 9, and then compressing in vacuo at 150°C at a pressure of 100 g/cm²,

### INDUSTRIAL APPLICABILITY

The back sheet of the present invention can be formed by using a coating, and therefore, the thickness thereof can be made thinner as compared with a conventional back sheet produced by laminating a sheet, thus making it possible to make the back sheet thinner and lighter. In addition, lowering of mechanical strength due to decrease in a coating thickness can be compensated for by curing (crosslinking) with a curable functional group.

Also, for example, adhesion to the water impermeable sheet can be improved by introducing functional group to the fluorine-containing polymer even without adding tetraalkoxysilane or the like.

Other effects of the present invention are explained herein by means of specific embodiments.

## Claims

1. A solar cell module provided with a back sheet having, on a water-impermeable sheet at the opposite side of a sealant layer of the solar cell module, a cured coating film of a coating material comprising a fluorine-containing polymer, **characterized in that** the fluorine-containing polymer has a curable functional group,
wherein the cured coating film is adhered directly to the water-impermeable sheet, and
a white pigment or a black pigment is dispersed in the cured coating film.

2. The solar cell module according to claim 1,
wherein the curable functional group of the fluorine-containing polymer is hydroxyl, carboxyl or amino,
the coating material further comprises a curing agent,
when the curable functional group of the fluorine-containing polymer is hydroxyl, the curing agent is an isocyanate curing agent, a melamine resin, a silicate compound or isocyanate-containing silane compound,
when the curable functional group of the fluorine-containing polymer is carboxyl, the curing agent is an amino curing agent or an epoxy curing agent, and
when the curable functional group of the fluorine-containing polymer is amino, the curing agent is a carbonyl-containing curing agent, an epoxy curing agent or an acid anhydride curing agent.

3. The solar cell module of claim 1 or 2, wherein the water-impermeable sheet is a silicon-deposited polyester sheet or a metal sheet.

4. The solar cell module of any of claims 1 to 3, wherein the fluorine-containing polymer having curable functional group is a fluorine-containing tetrafluoroethylene polymer having a curable functional group.

5. The solar cell module of any of claims 1 to 4, wherein the coating material is a solvent coating composition.

6. The solar cell module of any of claims 1 to 5, wherein the sealant is ethylene/vinyl acetate copolymer.

## Patentansprüche

1. Solarzellenmodul, bereitgestellt mit einer Rückplatte, die auf einer wasserundurchlässigen Platte auf der gegenüberliegenden Seite einer Abdichtungsschicht des Solarzellenmoduls einen gehärteten Beschichtungsfilm aus einem Beschichtungsmaterial aufweist, das ein fluorhaltiges Polymer umfasst, **dadurch gekennzeichnet, dass** das fluorhaltige Polymer eine aushärtbare funktionelle Gruppe aufweist,
wobei der ausgehärtete Beschichtungsfilm direkt an der wasserundurchlässigen Platte haftet, und
ein weißes Pigment oder ein schwarzes Pigment in dem ausgehärteten Beschichtungsfilm dispergiert ist.

2. Solarzellenmodul nach Anspruch 1,
wobei die aushärtbare funktionelle Gruppe des fluorhaltigen Polymers Hydroxyl, Carboxyl oder Amino ist,
das Beschichtungsmaterial weiter ein Aushärtemittel umfasst,
wenn die aushärtbare funktionelle Gruppe des fluorhaltigen Polymers Hydroxyl ist, das Aushärtemittel ein Isocyanat-Aushärtemittel, ein Melaminharz, eine Silicatverbindung oder isocyanathaltige Silanverbindung ist,
wenn die aushärtbare funktionelle Gruppe des fluorhaltigen Polymers Carboxyl ist, das Aushärtemittel ein Amino-Aushärtemittel oder ein Epoxy-Aushärtemittel ist, und
wenn die aushärtbare funktionelle Gruppe des fluorhaltigen Polymers Amino ist, das Aushärtemittel ein carbonylhaltiges Aushärtemittel, ein Epoxy-Aushärtemittel oder ein Säureanhydrid-Aushärtemittel ist.

3. Solarzellenmodul nach Anspruch 1 oder 2, wobei die wasserundurchlässige Platte eine Polyesterplatte mit abgeschiedenem Silizium oder eine Metallplatte ist.

4. Solarzellenmodul nach einem der Ansprüche 1 bis 3, wobei das fluorhaltige Polymer mit einer aushärtbaren funktionellen Gruppe ein fluorhaltiges Tetrafluorethylenpolymer ist, das eine aushärtbare funktionelle Gruppe aufweist.

5. Solarzellenmodul nach einem der Ansprüche 1 bis 4, wobei das Beschichtungsmaterial eine Lösungsmittelbeschichtungszusammensetzung ist.

6. Solarzellenmodul nach einem der Ansprüche 1 bis 5, wobei die Abdichtung Ethylen-/Vinyl-Acetat-Copolymer ist.

## Revendications

1. Module de cellule solaire pourvu d'une feuille arrière présentant, sur une feuille imperméable à l'eau sur le côté opposé d'une couche d'étanchéité du module de cellule solaire, un film de revêtement durci d'un matériau de revêtement comprenant un polymère contenant du fluor, **caractérisé en ce que** le polymère contenant du fluor présente un groupe fonctionnel durcissable,
dans lequel le film de revêtement durci adhère directement à la feuille imperméable à l'eau, et
un pigment blanc ou un pigment noir est dispersé dans le film de revêtement durci.

2. Module de cellule solaire selon la revendication 1,
dans lequel le groupe fonctionnel durcissable du polymère contenant du fluor est de l'hydroxyle, du carboxyle ou de l'aminé,
le matériau de revêtement comprend en outre un agent de durcissement,
lorsque le groupe fonctionnel durcissable du polymère contenant du fluor est de l'hydroxyle, l'agent de durcissement est un agent de durcissement d'isocyanate, une résine de mélamine, un composé de silicate ou un composé de silane contenant de l'isocyanate,
lorsque le groupe fonctionnel durcissable du polymère contenant du fluor est du carboxyle, l'agent de durcissement est un agent de durcissement d'aminé ou un agent de durcissement d'époxy, et
lorsque le groupe fonctionnel durcissable du polymère contenant du fluor est de l'aminé, l'agent de durcissement est un agent de durcissement contenant du carbonyle, un agent de durcissement d'époxy ou un agent de durcissement anhydride d'acide.

3. Module de cellule solaire selon la revendication 1 ou 2, dans lequel la feuille imperméable à l'eau est une feuille de polyester à dépôt de silicium ou une feuille métallique.

4. Module de cellule solaire selon l'une quelconque des revendications 1 à 3, dans lequel le polymère contenant du fluor présentant un groupe fonctionnel durcissable est un polymère de tétrafluoroéthylène contenant du fluor présentant un groupe fonctionnel durcissable.

5. Module de cellule solaire selon l'une quelconque des revendications 1 à 4, dans lequel le matériau de revêtement est une composition de revêtement à solvant.

6. Module de cellule solaire selon l'une quelconque des revendications 1 à 5, dans lequel le produit d'étanchéité est un copolymère éthylène/acétate de vinyle.
